# EUROPEAN PATENT SPECIFICATION

(11) **EP 1 548 275 B1**
(45) Date of publication and mention of the grant of the patent: **28.04.2010**
(21) Application number: 03425763.4
(22) Date of filing: 28.11.2003
(51) Int. Cl.: F02P 3/04, H03K 17/042

(54) **Control circuit for an electronic driving device of inductive loads, in particular for a device with an input signal having, at the high logic state, non optimal voltage value**
Steuerschaltung für ein elektronisches Treibergerät für induktive Lasten, insbesondere für ein Gerät dessem Eingangssignal in einem hohen Logikzustand einen nichtoptimalen Spannungswert besitzt
Circuit de commande pour un dispositif d'attaque électronique de charges inductives, en particulier pour un dispositif avec un signal d'entrée ayant, dans l'état logique haut, une tension de valeur non-optimale

(43) Date of publication of application: 29.06.2005
(73) Proprietor: STMicroelectronics Srl, 20041 Agrate Brianza (MB) (IT)
(72) Inventor: Torres, Antonino, 95125 Catania (IT); Torrisi, Giovanni Luca, 95100 Catania (IT)
(74) Representative: Ferrari, Barbara

(56) References cited:
- EP-A- 1 355 063
- US-A1- 2002 109 417
- US-A1- 2003 116 149
- PALARA S ET AL: "Modern electronic ignition in VIPower technology" POWER SEMICONDUCTOR DEVICES AND ICS, 1993. ISPSD '93., PROCEEDINGS OF THE 5TH INTERNATIONAL SYMPOSIUM ON MONTEREY, CA, USA 18-20 MAY 1993, NEW YORK, NY, USA,IEEE, US, 18 May 1993 (1993-05-18), pages 218-222, XP010116891 ISBN: 0-7803-1313-5

## Description

### Field of application

The present invention relates to a control circuit for an electronic driving device of inductive loads.

More specifically, the invention relates to a control circuit for an electronic driving device of inductive loads, of the type comprising at least a control block activated by a trigger signal and output-connected to a control terminal of a power element connected in turn to an inductive load.

More particularly, the invention relates to a control circuit for an electronic driving device of inductive loads, in electronic ignition applications and smart power devices, and the following description is made with reference to this field of application for convenience of illustration only.

### Prior art

As it is well known, in smart power devices, a linear control circuit is generally capable of driving a power element, also allowing the highest voltage and deliverable current to be protected and diagnostic functions to be performed.

These devices are powered in two different modes:
- a first mode provides the possibility of feeding the control circuit by means of a battery;
- the other mode provides the use as supply voltage of a high-state trigger signal, coming from the control circuit itself.

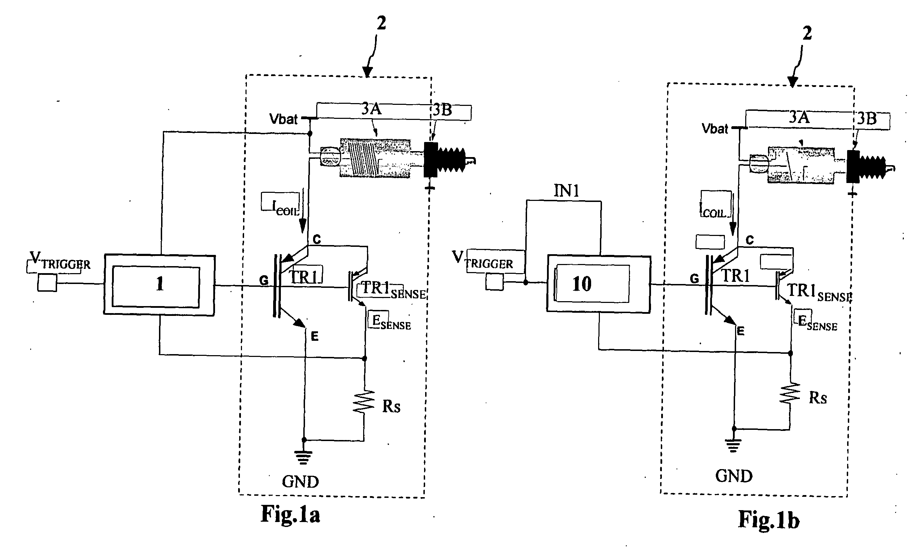

In particular, figure 1a shows a known solution, a control block 1 driving a first power element, in particular an IGBT transistor TR1 of an electronic device 2. The block 1 is powered by a supply voltage Vbat and activated by a trigger signal V_{TRIGGER}.

The first power element TR1 is inserted between a first voltage reference, in particular a supply voltage Vbat and a second voltage reference, for example a ground GND and it has a first conduction terminal, in particular a collector terminal C, connected to the first voltage reference Vbat, a second conduction terminal, in particular an emitter terminal E, connected to the ground GND, as well as a control terminal, in particular a gate terminal G connected to the control block 1. The first power element TR1 is also connected to an inductive load, for example a primary winding 3A of a coil, connected in turn to the supply voltage reference Vbat and to an igniter plug of the coil itself.

A second power element, in particular an IGBT sensing transistor TR1_{SENSE}, and a sensing resistance Rs are connected in series to each other and in parallel between the terminals C and E of the first power element.

In conduction, the two power elements TR1 and TR1_{SENSE} are crossed by different fractions of a same conduction current I_{COIL}.

Figure 1b shows a second known solution wherein the components and signals being already present in figure 1a will keep the same label; figure 1b shows a control block 10, changed with respect to block 1. The supply voltage of block 10 coincides with the voltage at the high state of the trigger signal, being used in the meantime to activate the block.

The object of the present invention relates to the family of the products shown in figure 1b which, not using an external power supply, can be assembled in simpler and cheaper packages like three-pin-packages.

For these devices a specification is defined, among the others, concerning the lowest and the highest output current I_{COIL} and the lowest and the highest voltage of the control signal V_{TRIGGER}.

In other words, it is necessary that the electronic device 2 correctly operates even in the worst case occurring for low battery voltages Vbat and at extreme temperatures, when the trigger voltage V_{TRIGGER}, at the high state, can be reduced; for example, being the signal ground separated from the power ground, the real voltage being applied between the gate G and emitter E terminals of said first power element TR1 is further reduced by the voltage fall ΔV introduced by connection cables and connectors.

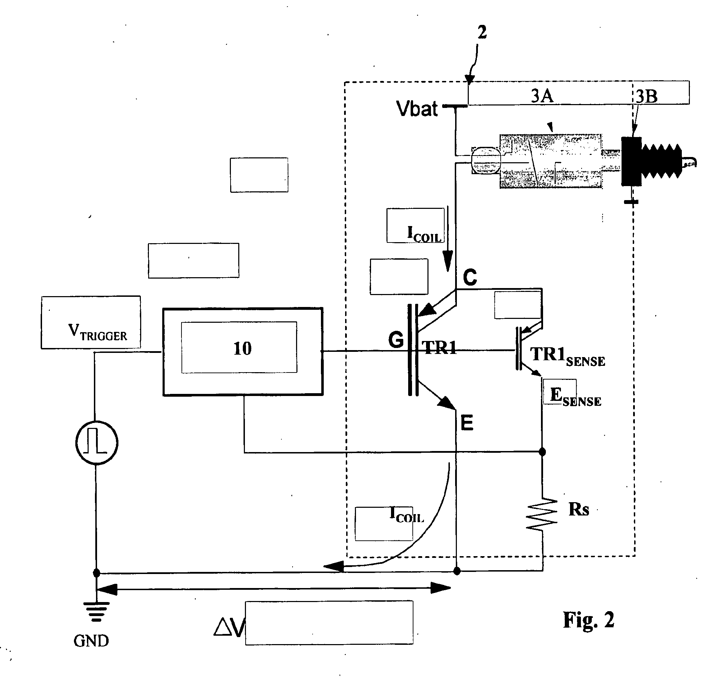

Figure 2 shows the same control block 10 of figure 1b, wherein the voltage fall introduced by cables and connectors is also underlined; the components and signals being already present in figure 1b will keep the same label also in figure 2.

For electronic ignition applications, in the automotive field, under "normal" operating conditions, it is traditionally required that a power element, in the case of figure 2 the first power element TR1, is capable of delivering an output current I_{COIL} no lower than 17A, with a trigger signal V_{TRIGGER} at the input of the block whose intensity is equal to 5V.

It can however happen that, under awful operating conditions, the voltage value of the trigger signal V_{TRIGGER} is reduced up to 2.5V.

In the non limiting case wherein the power element TR1 is an IGBT transistor, the highest voltage being applicable on the gate terminal G is given by the trigger voltage V_{TRIGGER} minus the voltage fall ΔV introduced by the control block 10.

Therefore, the highest output current I_{COIL} deliverable by the device is also set.

In such a situation, it is very difficult to meet the required specification concerning the minimum output current I_{COIL} of 17A, with said trigger signal V_{TRIGGER} at the input of the 5V-block, unless an IGBT transistor with oversized area is used.

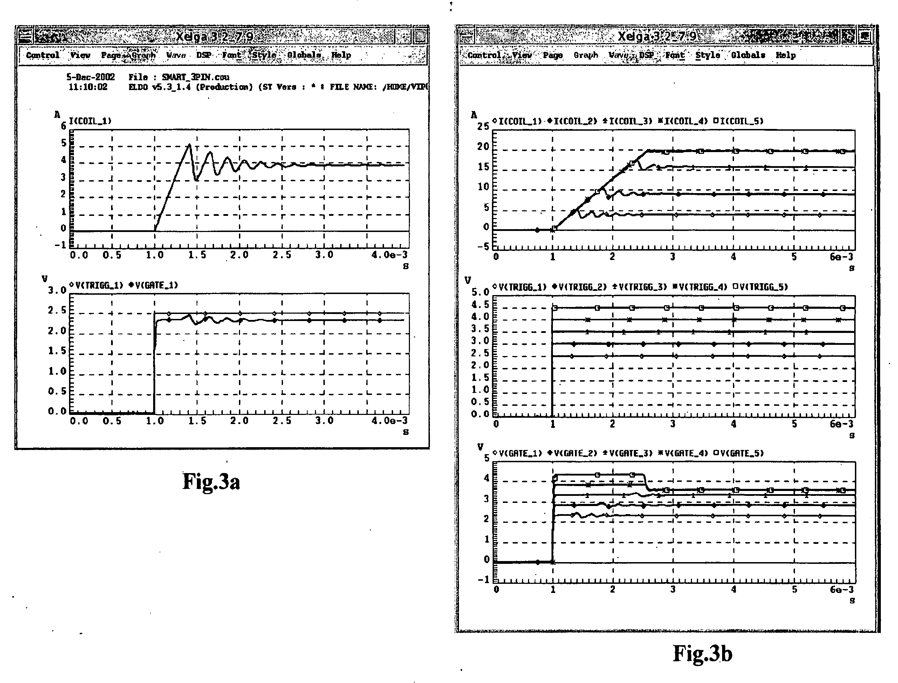

Figures 3a and 3b shows in a series of graphs signals related to simulations on the block of figure 2 performed for the first power element TR1, in particular an IGBT transistor whose active area is equal to 10 mm², driven by the control block 10 limiting the output current I_{COIL} to 20A.

Figure 3a relates to the case of the trigger voltage V_{TRIGGER} at the high state of 2.5V and figure 3b quotes the simulation results as the amplitude of said voltage varies.

When the trigger voltage V_{TRIGGER} is 2.5V [V(TRIGG_1)], the output current I(COIL_1) keeps lower than 4 A, i.e. quite lower than the predetermined limitation current, since the voltage V(GATE_1) calculated on the gate terminal G corresponds to about 2.3V.

When the trigger signal V_{TRIGGER} reaches a low state, the IGBT transistor TR1 is disabled and the power accumulated in the primary winding 3A of a coil transfers to the secondary winding generating a spark on the igniter plug 3B.

When the reckoned current in the collector terminal C of said IGBT transistor TR1 is too low, the accumulated power can be insufficient for generating the mixture combustion in the explosion chamber, with the subsequent misfiring phenomenon which is, as it is well known, very damaging for the motor.

From the simulations of figure 3b it can thus be appreciated how the current ICOIL, to reach the limitation value of 20A, requires a trigger signal V_{TRIGGER} whose amplitude is no lower than 4V.

To overcome the above-mentioned problems, the prior art suggests the use of a charge pump fed by a trigger signal V_{TRIGGER}, capable of generating an output voltage being sufficiently high as to conveniently bias the gate terminal G of said IGBT transistor TR1, allowing thus the current ICOIL required by the application to be delivered therefrom.

Although advantageous under several aspects, this solution has a serious drawback: the noise generated by the inner oscillator of the charge pump can cause electromagnetic noises making the device incompatible with the regulations.

Moreover, these noises, reflecting also on the voltage of said collector terminal C, are transferred to the coil secondary winding, by means of the turn ratio, and they can generate undesired overvoltages.

To remove this kind of problem, it would be thus necessary to further increase the circuit complexity of the control block 10, by inserting filters.

Also known from the US Patent Application published under No. U3 2003/0116149 in the name of Kohno et al. is a vehicle-mounted ignitor comprising a circuit for supplying an oscillation suppress current, in turn inserted between a collector terminal and a gate electrode of an IGBT. In particular, the described circuit comprises a resistor and a diode, connected in series to each other, as well as a by-pass MOS transistor, connected between this series connection and the emitter terminal of the IGBT.

The technical problem underlying the present invention is to provide a control circuit of electronic devices, having such structural and functional features as to ensure also in the worst case, i.e. with a reduced amplitude of the trigger signal, a sufficiently high current as to avoid ignition problems, overcoming the limits and/or drawbacks still affecting the devices realised according to the prior art.

### Summary of the Invention

The solution idea underlying the present invention is to insert an auxiliary current generator capable of delivering an auxiliary current to be added to the current outputted by the control circuit in order to bias, according to the provided specifications, the control terminal of the controlled device power element.

On the basis of this solution idea the technical problem is solved by a circuit as previously indicated and defined in the characterising part of claim 1.

The features and advantages of the device according to the invention will be apparent from the following description of an embodiment thereof given by way of non-limiting example with reference to the attached drawings.

### Brief description of the drawings

In the drawings:
- Figure 1a schematically shows a first control block, fed by a battery, driving a power element of an electronic device driving an inductive load, according to the prior art;
- Figure 1b schematically shows a second control block, fed by a trigger signal, driving said power element of said electronic device driving an inductive load, according to the prior art;
- Figure 2 schematically shows said second control block, fed by said trigger signal, driving said power element of said electronic device and wherein a voltage fall introduced by cables and connectors is also underlined, according to the prior art;
- Figures 3a and 3b show, in equally-time-based diagrams, the evolution of voltage and current waveforms obtained by simulating the operation of said electronic device of figure 2, according to the prior art;
- Figure 4 schematically shows a portion of a semiconductor integrated circuit comprising a power element equipped with a bonding pad for the extraction of a collector voltage value;
- Figure 5 schematically shows a control circuit realised according to the invention for a power element of an electronic driving device of an inductive load, according to the invention;
- Figure 6 shows a typical curve of a JFET structure being integrated inside said control circuit, according to the invention;
- Figure 7 schematically shows a testing circuit for the optional evaluation of a particular configuration of the control circuit of figure 5, according to the invention.

### Detailed description

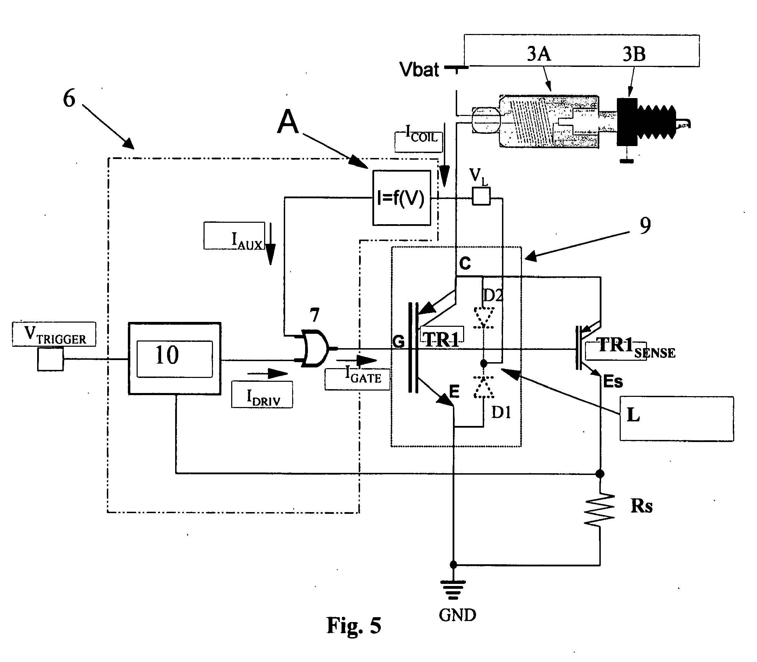

With reference to the figures, in figure 5 the components and signals being present also in figure 2 of the prior art will keep the numbers thereof.

Figure 5 shows a control circuit 6 receiving at its input a trigger signal V_{TRIGGER} and a collector voltage value V_{L} and outputting a current value I_{GATE} driving a first power element, particularly an IGBT transistor TR1 of a driving circuit 9 of inductive loads.

In particular, the control circuit 6 comprises a control block 10 receiving, as in the prior art, at its input said trigger signal V_{TRIGGER} and generating a first current I_{DRIV}.

The control circuit 6 also comprises, according to the invention, a current generator block A receiving at its input said collector voltage V_{L} and producing a second current, in particular an auxiliary current I_{AUX}.

Advantageously, according to the invention, said input voltage V_{L} of the control circuit 6, by means of the auxiliary current I_{AUX} generator block A, is detected in a point L coinciding with a terminal, in particular the cathode terminal which is common to two intrinsic diodes D1 and D2 located in series between the collector and the emitter of said power element TR1 of said electronic driving device 9 of inductive loads.

Said voltage V_{L} is proportional to the collector voltage of said power element TR1 and it is drawn in an area located between the substrate n and p of the physical structure of the transistor itself.

Advantageously, according to the invention, the contributions of said currents - first I_{DRIV} and second I_{AUX} - are added, by means of a logic gate OR, and they output said current I_{GATE} to control said power element TR1 of said electronic driving device 9 of inductive loads.

Said power element TR1 is associated, as already described in the prior art, to a second power element, in particular an IGBT sensing transistor TR_{SENSE}.

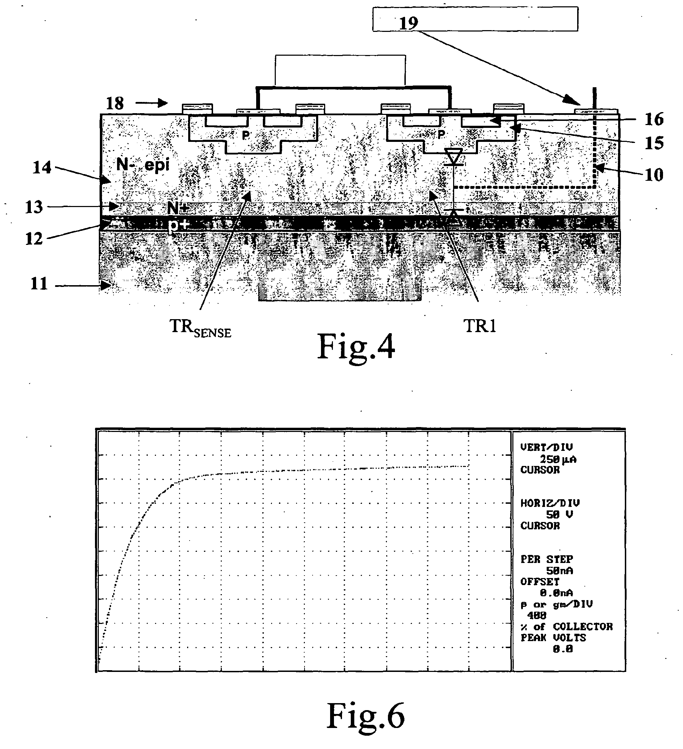

Figure 4 shows the structure used to draw said voltage V_{L} from said IGBT transistor TR1 of said electronic driving device 9 of inductive loads, used to feed said auxiliary current I_{AUX} generator block A.

This figure 4 schematically shows an integrated structure comprising the first power element TR1.

Advantageously, according to the invention, a bonding pad is provided near the edge structure of said power element TR1 in order to draw the value of the collector voltage V_{L}.

The composed structure of the transistor TR1 comprises, on the collector layer 11, a first semiconductor layer 12 of a first conductivity type P, heavily doped (P+), topped by a second semiconductor layer 13 of a second conductivity type (N), heavily doped (N+).

On said second semiconductor layer 13 an epitaxial layer 14 of said second conductivity (N) type, weakly doped (N-), is provided and wherein wells 15 of conductivity P are formed. Pairs of active areas 16 of conductivity N with electrodes 18 are realised in the wells 15.

The additional pad 19 is located on the edge of the transistor TR1 structure; by means of said pad 19, the collector voltage V_{L} of said transistor is drawn, and it is brought back to the input of said auxiliary current I_{AUX} generator block A.

Figure 4 also shows, overlapped, the circuit equivalent of said connection 10 represented by the series of two diodes with common cathode.

Advantageously, according to the invention, by using a high voltage technology, such as the ViPower technology, the auxiliary current IAUX generator block A can be realised with a J-FET transistor structure [(I=f(V)] integrated inside the control circuit 6. This solution has the advantage of pinching at high voltage, as shown in the curve of figure 6.

A second possible optional solution to realise the auxiliary current I_{AUX} generator block A is the use of a third power element, in particular a JFET transistor TR2 which can be integrated inside the same IGBT transistor TR1 of said electronic driving device 9 of inductive loads; advantageusly, according to the invention, in this case, said control circuit 6 can be realised with a low voltage technology.

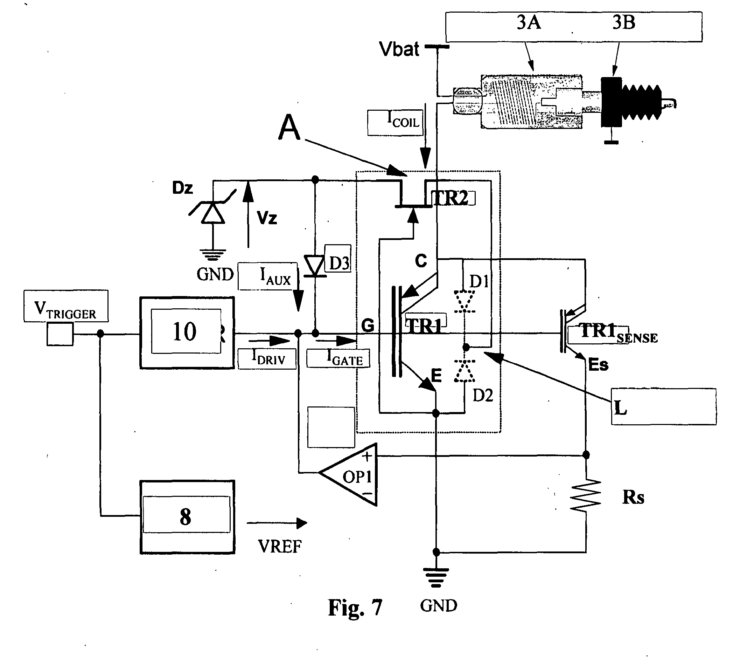

In particular, figure 7 describes a circuit realised to evaluate the effectiveness of this second solution.

As it can appreciated in figure 7, the block A has been realised with said JFET transistor TR2 monolithically integrated inside the IGBT transistor TR1 of said driving circuit 8 of inductive loads.

In the evaluation circuit of the effectiveness of this second solution, the JFET transistor TR2 has the control terminal coinciding with the emitter E of said transistor TR1, a first conduction terminal connected to said cathode terminal L being common to said two intrinsic diodes D1 and D2 and a second conduction terminal coupled to the gate terminal G of the transistor TR1 of said driving circuit 8 of inductive loads. A diode D3 is inserted between said second conduction terminal of the JFET transistor TR2 and the gate terminal G of the transistor TR1, while a Zener diode Dz is connected between the second conduction terminal of the JFET transistor TR2 and the ground GND.

An operational amplifier OP1 is also provided, serving as current limiter, with an inverting input (-) connected to a generator block 8 of reference voltage VREF, receiving at its input said trigger signal V_{TRIGGER}, a non inverting input (+) connected to the emitter terminal E_{SENSE} of said sensing transistor TR1_{SENSE} and an output connected to the gate terminal G of the transistor TR1.

The voltage reference block 8 and the operational amplifier OP1 serving as current limiter allow the limitation function of the highest current outputted from said first transistor TR1 to be performed.

To implement the evaluation circuit of the effectiveness of this second solution, it is necessary that said control block 10 has the following features:
- it delivers said current I_{DRIV} when the input voltage V_{TRIGGER} is higher than the output voltage thereof, coinciding with the voltage Vg of the control terminal G of said transistor TR1;
- it does not absorb current, similarly to a diode.

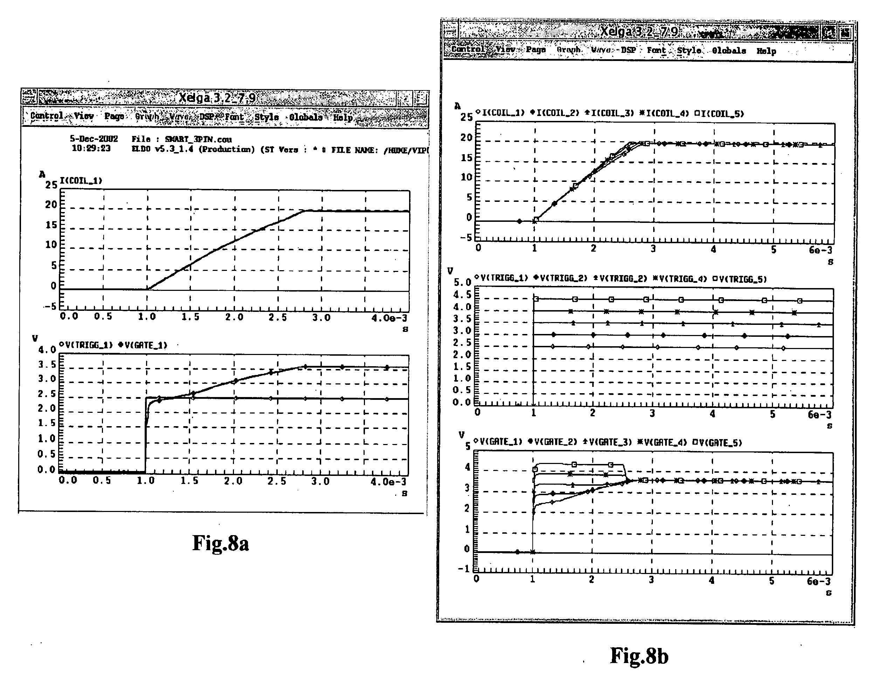

Figures 8a and 8b quote the result of the simulation of the circuit of figure 7.

In figure 8a it can be noticed how the voltage V(GATE_1), which can be applied on the control terminal G of said transistor TR1, can overcome the trigger voltage V(TRIGG_1) at the high state, which is the supply voltage of the control block, allowing said transistor TR1 to operate with a high output current.

The control terminal G capacity is charged in two following steps:
- in the first step the current I_{DRIV} charges the control terminal G of said transistor TR1, until the gate voltage is lower than the V_TRIGGER voltage at the high state.
- in a second step, when I_{DRIV} is void, the control terminal G of said transistor TR1 is charged only by the current I_{AUX} coming from said JFET transistor TR2.

The voltage on said control terminal G of said transistor TR1 is at the end limited by the operational amplifier OP1 serving as current limiter, operating in adjustment, in order to have the predetermined coil current I(COIL_1).

In figure 8b it can be noticed how the limitation current is always reached, as the amplitude of the trigger voltage VTRIGGER varies.

It can be seen how, as the amplitude of the signal VTRIGGER varies, the corresponding voltage V(GATE) of the control terminal G of said transistor TR1 reaches a value which is sufficient to let the collector current reach the limitation value.

This type of solution allows the device to reach the nominal current even in the worst case, in order to always charge the coil in an optimal way, and to have in the turn-off step the convenient amount of energy available.

In conclusion, the present invention provides a control circuit of devices driven by input signals having, at the high logic state, non optimal voltage values.

## Claims

1. An electronic driving device (9) configured for driving inductive loads, said electronic driving device (9) comprising a control circuit (6) comprising at least a control block (1, 10) activated by a trigger signal (V_{TRIGGER}) and output-connected to a control terminal of a power element (TR1) of said electronic driving device (9) and an auxiliary current generator (A), **characterised in that** said auxiliary current generator (A) includes a JFET transistor capable of delivering an auxiliary current (I_{AUX}) to be added to the current (I_{DRIV}) outputted by said control block (1, 10) to supply a driving current (I_{GATE}) and **in that** said auxiliary current (I_{AUX}) is generated by means of a voltage (V_{L}) bering proportional to the collector voltage of said power element (TR1) of said electronic driving device (9) of inductive loads.

2. A device according to claim 1, wherein said power element (TR1) is an IGBT transistor.

3. A device according to claim 1 comprising an epitaxial layer (14) of said power element (TR1) connected to a pad (19) on the edge structure of said power element (TR1), said epitaxial layer (14) configured for drawing said auxiliary current (I_{AUX}).

4. A device according to claim 1, wherein the components of said control circuit (6) are realised with a high voltage technology .

5. A device according to claim 1, wherein said J-FET transistor is integrated inside said control circuit (6).

6. A device according to claim 1, wherein said JFET transistor pinches at high voltage.

7. A device according to claim 1, wherein said JFET transistor is integrated inside said power element (TR1).

8. A device according to claim 7, wherein said JFET transistor is realised with a low voltage technology.

9. A testing device of the device according to claim 8, **characterised**
**in that** it comprises a further voltage reference block (8) and an operational amplifier (OF1) for operating as current limiter.

10. A device according to claim 9, wherein said control block (10) is configured for delivering said current (I_{DRIV}) in correspondence with an input voltage (V_{TRIGGER}) being higher than the voltage of the gate terminal (G) of said transistor (TR1).

## Patentansprüche

1. Zum Ansteuern induktiver Lasten konfigurierte elektronische Ansteuervorrichtung (9), wobei die elektronische Ansteuervorrichtung (9) eine Steuerschaltung (6), welche mindestens einen Steuerungsblock (1, 10) beinhaltet, welcher durch ein Trigger-Signal (V_{TRIGGER}) aktiviert wird und der am Ausgang mit einem Steuerungsanschluss eines Leistungselementes (TR1) der elektronischen Ansteuervorrichtung (9) verbunden ist, sowie einen Hilfsstromgenerator (A) umfasst, **dadurch gekennzeichnet, dass** der Hilfsstromgenerator (A) einen JFET-Transistor beinhaltet, welcher fähig ist, einen zum Strom (I_{Driv}), welcher durch den Steuerungsblock (1, 10) zum Liefern eines Ansteuerungsstromes (I_{GATE}) ausgegeben wird, hinzuzufügenden Hilfsstrom (I_{AUX}) zu liefern, und **dadurch**, dass der Hilfsstrom (I_{AUX}) mittels einer Spannung (V_{L}) erzeugt wird, welche der Kollektorspannung des Leistungselementes (TR1) der elektronischen Ansteuervorrichtung (9) für induktive Lasten proportional ist.

2. Vorrichtung nach Anspruch 1, wobei das Leistungselement (TR1) ein IGBT-Transistor ist.

3. Vorrichtung nach Anspruch 1, umfassend eine Epitaxialschicht (14) des Leistungselementes (TR1), welche mit einem Feld (19) an der Kantenstruktur des Leistungselements (TR1) verbunden ist, wobei die Epitaxialschicht (14) zum Ziehen des Hilfsstromes (I_{AUX}) konfiguriert ist.

4. Vorrichtung nach Anspruch 1, wobei die Komponenten der Steuerungsschaltung (6) mit einer Hochspannungstechnologie realisiert sind.

5. Vorrichtung nach Anspruch 1, wobei der J-FET-Transistor innerhalb der Steuerungsschaltung (6) integriert ist.

6. Vorrichtung nach Anspruch 1, wobei der JFET-Transistor bei einer hohen Spannung abklemmt.

7. Vorrichtung nach Anspruch 1, wobei der JFET-Transistor innerhalb des Leistungselementes (TR1) integriert ist.

8. Vorrichtung nach Anspruch 7, wobei der JFET-Transistor in einer Niederspannunstechnologie realisiert ist.

9. Testvorrichtung für die Vorrichtung nach Anspruch 8, **dadurch gekennzeichnet, dass** sie einen weiteren Bezugsspannungsblock (8) und einen Operationsverstärker (OP1) umfasst, welcher als Strombegrenzer arbeitet.

10. Vorrichtung nach Anspruch 9, wobei der Steuerungsblock (10) zum Liefern des Stromes (I_{DRIV}) entsprechend einer Eingangsspannung (V_{TRIGGER}), die höher ist als die Spannung am Gate-Anschluss (G) des Transistors (TR1), konfiguriert ist.

## Revendications

1. Dispositif d'attaque électronique (9) configuré pour attaquer des charges inductives, ledit dispositif d'attaque électronique (9) comprenant un circuit de commande (6) comprenant au moins un bloc de commande (1, 10) activé par un signal de déclenchement (V_{TRIGGER}) et connecté en sortie à une borne de commande d'un élément de puissance (TR1) dudit dispositif d'attaque électronique (9) et un générateur de courant auxiliaire (A), **caractérisé en ce que** ledit générateur de courant auxiliaire (A) comprend un transistor JFET capable de livrer un courant auxiliaire (I_{AUX}) à ajouter au courant (I_{DRIV}) délivré par ledit bloc de commande (1, 10) pour fournir un courant d'attaque (I_{GATE}) et **en ce que** ledit courant auxiliaire (I_{AUX}) est généré au moyen d'une tension (V_{I}) qui est proportionnelle à la tension de collecteur dudit élément de puissance (TR1) dudit dispositif d'attaque électronique (9) de charges inductives.

2. Dispositif selon la revendication 1, dans lequel ledit élément de puissance (TR1) est un transistor IGBT.

3. Dispositif selon la revendication 1, comprenant une couche épitaxiale (14) dudit élément de puissance (TR1) connectée à un patin (19) sur la structure de bord dudit élément de puissance (TR1), ladite couche épitaxiale (14) étant configurée pour tirer ledit courant auxiliaire (I_{AUX}).

4. Dispositif selon la revendication 1, dans lequel les composants dudit circuit de commande (6) sont réalisés avec une technologie de haute tension.

5. Dispositif selon la revendication 1, dans lequel ledit transistor JFET est intégré à l'intérieur dudit circuit de commande (6).

6. Dispositif selon la revendication 1, dans lequel ledit transistor JFET pince à haute tension.

7. Dispositif selon la revendication 1, dans lequel ledit transistor JFET est intégré à l'intérieur dudit élément de puissance (TR1).

8. Dispositif selon la revendication 7, dans lequel ledit transistor JFET est réalisé avec une technologie de basse tension.

9. Dispositif de test du dispositif selon la revendication 8, **caractérisé en ce qu'**il comprend un autre bloc de référence de tension (8) et un amplificateur opérationnel (OP1) pour fonctionner en tant que limiteur de courant.

10. Dispositif selon la revendication 9, dans lequel ledit bloc de commande (10) est configuré pour livrer ledit courant (I_{DRIV}) en correspondance avec une tension d'entrée (V_{TRIGGER}) étant supérieure à la tension de la borne de grille (G) dudit transistor (TR1).
